# EUROPEAN PATENT APPLICATION

(11) **EP 2 955 252 A1**
(43) Date of publication of application: **16.12.2015**
(21) Application number: 13875504.6
(22) Date of filing: 01.11.2013
(51) Int. Cl.: C30B 13/28, C30B 29/06, C30B 13/26, C30B 13/30, C30B 15/00

(54) **METHOD FOR PREPARING SOLAR GRADE SILICON SINGLE CRYSTAL USING CZOCHRALSKI ZONE MELTING METHOD**

(30) Priority: 25.02.2013 CN 201310057877
(71) Applicant: Tianjin Huanou Semiconductor Material&Technology, Tianjin 300-384 (CN)
(72) Inventor: WANG, Yanjun, Tianjin 300384 (CN); ZHANG, Xuenan, Tianjin 300384 (CN); SHEN, Haoping, Tianjin 300384 (CN); QIAO, Liu, Tianjin 300384 (CN); LIU, Jia, Tianjin 300384 (CN); WANG, Zunyi, Tianjin 300384 (CN); LIU, Zheng, Tianjin 300384 (CN); SUN, Jian, Tianjin 300384 (CN)
(74) Representative: Sun, Yiming
(86) International application number: PCT/CN2013/086395
(87) International publication number: WO 2014/127646

(57) **Abstract**

The present invention discloses a method of preparing solar-grade silicon single crystals by using the Czochralsk zone-and float-zone process: in the equal-diameter growth process during the float-zone phase, under the control by the electric control system of a float-zone single crystal furnace, a downward-rotating motor alternates forward rotations and reverse rotations; said downward-rotating motor drives silicon single crystals to rotate by the preset forward angle or reverse angle. The present invention improves the radial resistivity variation of solar-grade silicon single crystals and solves the black heart problem with solar-grade silicon single crystals. Thus, the conversion efficiency of the solar cells manufactured using such solar-grade silicon single crystals can be increased.

## Description

### Technical Field

The present invention relates to the technical field of preparing silicon single crystals, specifically to a method of preparing solar-grade silicon single crystals by using the Czochralsk and float-zone process.

### Background Art

The technology of preparing silicon single crystals by using the Czochralsk and float-zone process overcomes the inherent defects with the production processes using the traditional Czochralsk method and float-zone process, facilitating large-scale production. Silicon single crystals prepared using the Czochralsk and float-zone process, cost-effective and characterized by being easily doped into special solid impurity elements, have a large market potential and application scope in the field of semiconductor materials. However, for the Czochralsk and float-zone silicon single crystals currently used in the field of solar energy, the single crystals rotate in a single direction during the float-zone phase in the preparation process. Therefore, during the process of gas phase doping, the dopant, oxygen, and carbon distribution is uneven, and the black heart phenomena, which are common in Czochralsk silicon single crystals, still occur. Moreover, the radial resistivity variation of the crystals is poor, affecting the conversion efficiency of the solar cells manufactured using such crystals.

### Description of the Invention

The technical problem that the present invention is intended to solve is to provide a method of preparing solar-grade silicon single crystals by using the Czochralsk and float-zone process, particularly suitable for improving the photovoltaic performance of solar-grade silicon single crystals.

In order to solve the aforesaid technical problem, the present invention adopts the following technical solution: a method of preparing solar-grade silicon single crystals by using the Czochralsk and float-zone process: in the equal-diameter growth process during the float-zone phase, under the control by the electric control system of a float-zone single crystal furnace, a downward-rotating motor alternates forward rotations and reverse rotations; said downward-rotating motor drives silicon single crystals to rotate by the preset forward angle and reverse angle.

Further, the ratio of said forward angle to said reverse angle is a preset value.

Further, the ratio of said forward angle to said reverse angle is 380:620.

Further, said forward angle is in the range 100° to 800°, and said reverse angle is in the range 50° to 750°.

The present invention has the following advantages and beneficial effects: The present invention introduces the bidirectional rotation process in the equal-diameter growth process for the preparation of solar-grade silicon single crystals, greatly improving the radial resistivity of solar-grade silicon single crystals; thus, the black heart problem with solar-grade silicon single crystals is solved, and the conversion efficiency of the solar cells manufactured using such solar-grade silicon single crystals can be increased.

### Description of the Drawings

Figure 1 shows a solar-grade silicon single crystal prepared using the prior art.
Figure 2 shows a solar-grade silicon single crystal prepared using the technical solution disclosed by an embodiment of the present invention.

### Embodiment

The present invention provides of preparing solar-grade silicon single crystals by using the Czochralsk float-zone process: in the equal-diameter growth process during the float-zone phase, under the control by the electric control system of a float-zone single crystal furnace, a downward-rotating motor alternates forward rotations and reverse rotations; the downward-rotating motor drives silicon single crystals to rotate by the preset forward angle and reverse angle; the ratio of the forward angle to the reverse angle is a preset value; the forward angle is preferably in the range 100° to 800°, and the reverse angle is preferably in the range 50° to 750°; the ratio of the forward angle to the reverse angle is preferably 380:620.

During the whole process of the preparation of solar-grade silicon single crystals, the forward angle to the reverse angle remain unchanged. In different processes for preparing solar-grade silicon single crystals, depending on preparation needs, different ratios of the forward angle to the reverse angle can be preset.

### Embodiment:

In the present embodiment, first, silicon single crystals are prepared using the Czochralsk method, formed, and then washed by etching; then, in the equal-diameter growth process during the float-zone phase, solar-grade silicon single crystals are pulled using the bidirectional rotation process; the steps are as follows:
1. Load 80 kg of block silicon polycrystals washed by etching into the quartz crucible in a Czochralsk furnace. Then, create a vacuum and charge argon. After vacuuming for 30 minutes to 60 minutes, when the pressure is lower than or equal to 100 millitorrs, charge argon until the vacuum pressure is lower than or equal to 14 millitorrs.
2. Before preheating, add cooling water. Press the heating button to heat, reaching a temperature in the range 1500°C to 1600°C. After all the block silicon polycrystals are melted, start the seed crystal rotation mechanism to lower and splice seed crystals.
3. When the liquid level has stabilized, perform necking. By using the seed crystals, pull out a neck segment with a diameter of about 8 mm and a length of 20 mm from the molten polycrystals.
4. Decrease the seed crystal raising speed. Set the raising speed to about 0.5 mm/min and perform shouldering. After about 60 minutes, increase the neck diameter from 8 mm to a range 140 mm - 150 mm.
5. Adjust the diameter sensor to control the pulling speed for equal-diameter crystal pulling; the equal-diameter growth time is 20 hours.
6. Decrease the crystal pulling speed and perform the tailing-in technique; the tailing-in time is 2 hours.
7. Raise the crystals so that they leave the liquid level. Press the furnace shutdown button to shut down the furnace. After the power meter returns to zero, cut off the power supply. Two hours later, stop the vacuuming by the main vacuum pump, and tap the polycrystalline rod.
8. Form the tapped polycrystalline rod and wash it by etching. Then, mount the rod on the crystal clamper in the float-zone furnace, and load 100 seed crystals on the seed crystal fixation clamp.
9. Place preheating fins around the seed crystals. Close the furnace door, create a vacuum, and charge argon. Then, heat the polycrystalline rod. In addition, set the doping value of the dopant air, and set the ratio of the forward angle to the reverse angle of motor rotations; set the ratio of the forward angle to the reverse angle to 380:620.
10. After preheating, perform material melting. When the polycrystals are melted, splice the seed crystals to molten silicon. After the splicing, perform reshaping and seeding on the melting zone.
11. Upon seeding completion, perform neck growth, achieving a neck diameter in the range 3 mm to 6 mm and a length in the range 20 mm to 100 mm.
12. Decrease the lower crystal speed, and keep the shouldering angle in the range 50°C to 70°C (when shouldering starts, turn on impurity gas supply, which enters the furnace chamber according to the value preset on the flow meter). When the required diameter is achieved by shouldering, perform equal-diameter growth. In this case, press the motor control button so that the motor alternates forward rotations and reverse rotations as programmed, at a forward angle of 380° and a reverse angle of 620°, until the single crystal equal-diameter growth phase is completed. Shut down the program so that the motor starts driving single crystals to rotate in a single direction.
13. When the loading is insufficient, start the tailing-in technique. After the tailing-in, stop charging the impurity gas. When the required single crystal diameter is achieved during the tailing-in technique, pull open the melting zone; the lower shaft drives the single crystals to continue moving downward, and the upper shaft drives the single crystals to move upward; stop the argon supply.
14. After 10 minutes to 60 minutes, when the crystal tail has gradually turned from red into black, remove and purge the furnace, and then take out the single crystals.

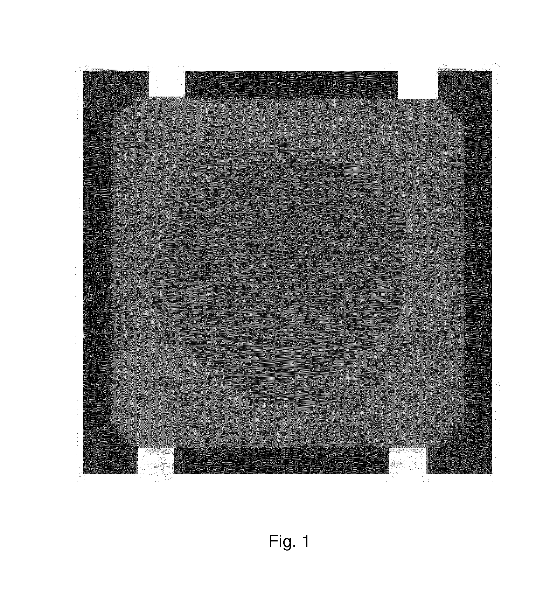

The radial resistivity variation (RRV) of a solar-grade silicon single crystal prepared using the Czochralsk and float-zone process according to the prior art is in the range 30% to 40%. As shown in Figure 1, a silicon single crystal manufactured according to the prior art has a black heart. The conversion efficiency of a solar cell manufactured using such a crystal is 21%, and a certain efficiency attenuation effect exists.

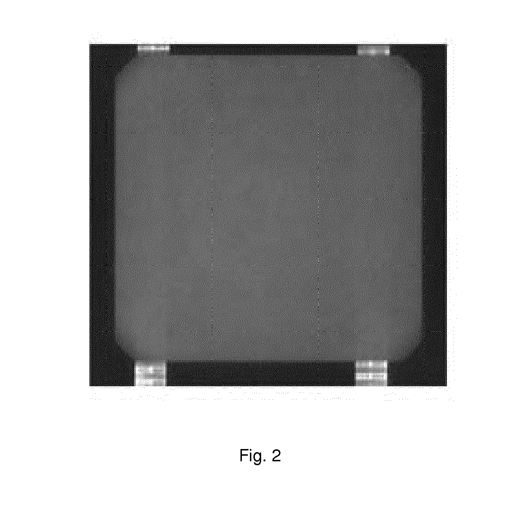

The radial resistivity variation (RRV) of a solar-grade silicon single crystal prepared using the present embodiment is 10%. As shown in Figure 2, such a crystal has no black heart. The conversion efficiency of a solar cell manufactured using such a crystal reaches 24%, and the cell efficiency attenuates little.

While the present invention has been particularly described above with reference to a preferred embodiment, it should be understood that said embodiment is not intended to limit the present invention.

Various equivalent modifications and improvements made without departing from the spirit or principle of the present invention should be encompassed by the disclosure herein.

## Claims

1. A method of preparing solar-grade silicon single crystals by using the Czochralsk and float-zone process, **characterized in that**, in the equal-diameter growth process during the float-zone phase, under the control by the electric control system of a float-zone single crystal furnace, a downward-rotating motor alternates forward rotations and reverse rotations; said downward-rotating motor drives silicon single crystals to rotate by the preset forward angle or reverse angle.

2. The method of preparing solar-grade silicon single crystals by using the Czochralsk float-zone process according to Claim 1, **characterized in that** the ratio of said forward angle to said reverse angle is a preset value.

3. The method of preparing solar-grade silicon single crystals by using the Czochralsk and float-zone process according to Claim 2, **characterized in that** the ratio of said forward angle to said reverse angle is 380:620.

4. The method of preparing solar-grade silicon single crystals by using the Czochralsk zone-and float-zone process according to Claim 1, **characterized in that** said forward angle is in the range 100° to 800°, and said reverse angle is in the range 50° to 750°.
